Europäisches Patentamt

European Patent Office

Office européen des brevets

(11) Publication number: **0 099 702**
**B1**

# EUROPEAN PATENT SPECIFICATION

(45) Date of publication of patent specification: **04.10.89**

(51) Int. Cl.⁴: **H 04 L 27/22, H 03 D 9/04**

(21) Application number: **83303972.0**

(22) Date of filing: **07.07.83**

(54) A frequency converter.

(30) Priority: **07.07.82 JP 117990/82**
**30.09.82 JP 172164/82**

(43) Date of publication of application:
**01.02.84 Bulletin 84/05**

(45) Publication of the grant of the patent:
**04.10.89 Bulletin 89/40**

(84) Designated Contracting States:
**DE FR GB IT NL**

(56) References cited:
US-A-3 594 651
US-A-3 665 304
US-A-3 789 316
US-A-4 048 566
US-A-4 061 979

NAVY TECHNICAL DISCLOSURE BULLETIN,
vol. 2, no. 10, October 1977, pages 49-51,
Arlington, US; E.F.ROBERTSON: "Automatic
frequency control"
IDEM.

(73) Proprietor: **FUJITSU LIMITED**
**1015, Kamikodanaka Nakahara-ku**
**Kawasaki-shi Kanagawa 211 (JP)**

(72) Inventor: **Miyo, Tokihiro**
**Fujitsu Ltd. Patent Department 1015**
**Kamikodanaka**
**Nakahara-ku Kawasaki 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:

PATENTS ABSTRACTS OF JAPAN, vol. 3, no.
6(E-85), 22nd January 1979, page 87 E85; & JP -
A - 53 134 353 (MITSUBISHI DENKI K.K.)
22-11-1978

A.BLANCHARD: "PHASE-LOCKED LOOPS",
Application to coherent receiver design, 1976,
pages 279-292, A Wiley-Interscience
Publication, John Wiley & Sons, New York, US;

**EP  0 099 702  B1**

(56) References cited:

**ARCHIV FÜR ELEKTRONIK &
UBERTRAGUNGSTECHNIK, vol. 34, no. 11,
November 1980, pages 438-444, Würzburg, DE;
R.F.WEBER: "Fangverhalten von
Phasenregelkreisen mit getastetem
Fehlersignal"**

## Description

This invention relates to a frequency converter.

A time division multiple access communication system using a PSK (phase shift keying) modulated wave signal has been proposed for employment in the field of satellite communications. In such a communication system, for example, as in other radio communication systems, a received radio frequency band signal is converted into a signal of a different, specified frequency by a frequency converter and thereafter this latter signal is demodulated. When demodulating such a signal, the frequency of the signal which is demodulated must be kept constant, having regard to the capabilities of and the requirements made of the circuit structure used. If a large frequency fluctuation occurs data error can arise and accurate demodulation becomes difficult.

Accordingly, in the proposed communication system mentioned above, automatic frequency control (AFC) has been effected by changing the oscillation frequency of a local oscillator used in a receiver for such frequency conversion, the automatic frequency control being effected in accordance with frequency fluctuations of a received signal.

However, the signal spectrum of a PSK modulated wave signal as mentioned above is widely spread and it is therefore difficult directly to extract from such a PSK modulated wave signal a reference signal for use in controlling AFC. That is, if deviation of the frequency of the received signal from a specific or nominal received signal frequency cannot be recognised, it is impossible to effect AFC in respect of the receiving signal.

It has been proposed, with the above problem in mind, that a pilot signal, having a constant relative frequency interval from the center frequency of the PSK modulated wave signal, be transmitted in such a way that it is superimposed on the PSK modulated signal. Here, the pilot signal, having a line spectrum, is used for identifying frequency deviations to enable AFC to be effected in relation to the received PSK modulated wave signal. However, with such a method, a communication frequency band and transmission facilities are required to accommodate the pilot signal, and this is disadvantageous especially in a satellite communication system because such a system will be severely restricted with regard to the permitted transmitting frequency band. Moreover, the addition of pilot signal transmission circuits results in an increase in system costs and a deterioration in system reliability.

In radio communication systems, particularly in a low speed time division multiple access (TDMA) satellite communication system which has recently been proposed, removal of all frequency fluctuations from a received signal, to avoid the need for such AFC, is extremely difficult, if not impossible.

Navy Technical Disclosure Bulletin, Vol. 2, No. 10, October 1977, pages 49 to 51, discloses an automatic frequency control for a short duty cycle pulsed radar receiver. An RF signal is mixed with the output of a local oscillator to provide an IF output which is divided into first and second IF signals. The first IF signal is fed, inter alia, to a SAW device which acts as a frequency discriminator. A sample and hold circuit receives the output of the SAW device and that of a limiter and multivibrator and provides a relatively fixed output to an AFC circuit the output of which is connected to the local oscillator.

According to the present invention there is provided a frequency converter, comprising:

a voltage controlled oscillator for generating a local signal;

mixing means, connected to receive the local signal and arranged to receive an input signal to be frequency converted, operable to mix the local signal and the input signal to provide a frequency converted output signal; and

discriminating means connected to receive the frequency converted output signal, operable to detect error in the frequency of that signal and to provide an error signal indicative of such error, the voltage controlled oscillator being controlled to alter the frequency of the local signal, to reduce such error, in dependence upon the error signal;

characterised in that the frequency converter further comprises:—

means for detecting a non-modulated portion of the input signal, on the basis of the frequency converted output signal, and to provide a control signal in correspondence to the detection of such a non-modulated portion, and

means operable under control of the said control signal to provide an error value based on the error signal output of the discriminating means when the non-modulated portion of the input signal is detected;

the voltage controlled oscillator being controlled on the basis of said error value when providing the local signal for frequency conversion of a modulated portion of the input signal received after the said non-modulated portion.

An embodiment of this invention provides a frequency converter which is capable of controlling the oscillation frequency of a local oscillator, without using a pilot signal as described above, and of maintaining constant the frequency of the frequency-converted output signal provided by the converter on the basis of the oscillation frequency of the local oscillator.

In a frequency converter embodying this invention, frequency discrimination is carried out only in relation to a non-modulated portion of a received signal, for example a received burst signal of a TDMA communication system utilising PSK modulated wave signals. A frequency discriminator output derived from such a non-modulated portion is held for a certain period and thereby is used as an oscillation frequency control signal of a local oscillator used for demodulating the PSK modulated signals.

Embodiments of the present invention can be employed in any circumstances in which a received modulated signal, to be demodulated after frequency conversion on the basis of the output of a local oscillator, provides non-modulated portions.

Thereby, the need for pilot signals can be avoided.

Embodiments of this invention are particularly suitable for use when the received modulated signal is a PSK signal, for example, in a TDMA satellite communication system as mentioned above.

Reference is made, by way of example, to the accompanying drawings, in which:

Figure 1 is a schematic block diagram of a frequency converter embodying this invention for handling a PSK input signal;

Figure 2 is a schematic time chart diagram comprising time charts (a), (b) and (c), illustrating burst signals of a TDMA communication system using PSK modulated signals, and for assistance in explaining circuit operations in an embodiment of this invention when employed in such a system;

Figure 3 is a schematic block diagram of sample-hold type integrating means used in an embodiment of this invention;

Figure 4 is a schematic block diagram of frequency discriminating means used in an embodiment of this invention;

Figure 5 comprises graphs (a), (b) and (c) illustrating characteristics of components of the frequency discriminating means of Figure 4, and of the frequency discriminating means as a whole;

Figure 6 is a schematic block diagram of a non-modulated signal portion detecting means as used in an embodiment of this invention.

The present invention will be described below with particular reference to its use in the context of a TDMA communication system using PSK burst signals, for example, a satellite communication system.

However, it will be appreciated that the present invention can be employed in other communication systems offering non-modulated signal portions and in which AFC is to be provided, without the use of a pilot signal.

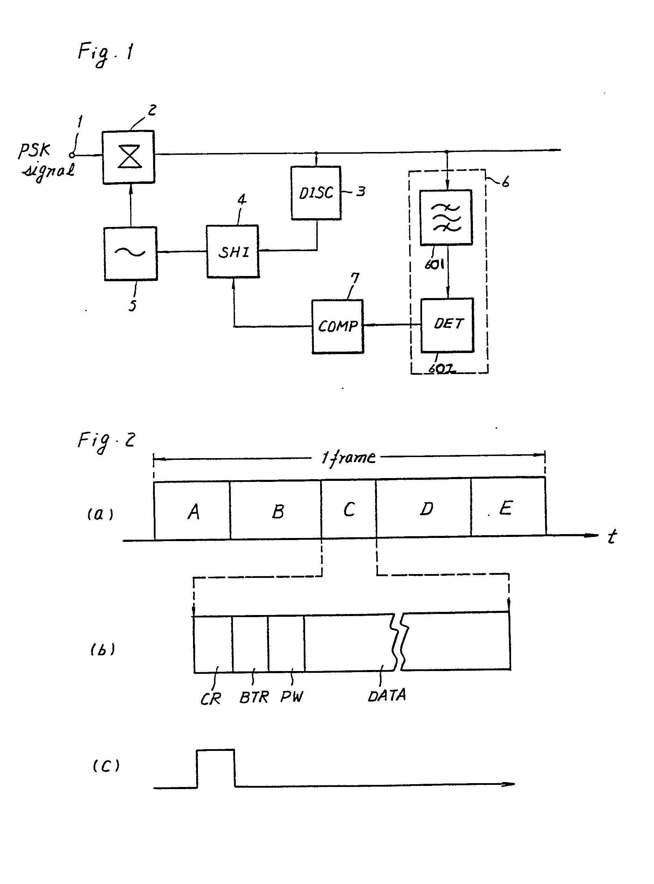

Figure 1 is a schematic block diagram of a frequency converter embodying this invention, in Figure 1, 1 is an input terminal to which a received PSK input signal is applied when the converter is in use; 2 is mixing means; 3 is frequency discriminating means; 4 is sample-hold type integrating means; 5 is a voltage controlled oscillator; 6 is means for detecting a non-modulated signal portion, comprising a band-pass filter 601 and means 602 for envelope detection, and 7 is a voltage comparator.

When the frequency converter is in use, the input terminal 1 receives a burst signal input consisting of a PSK modulated wave signal as shown in Figure 2(a). This burst signal input extends in time as indicated along time axis $t$ in Figure 2(a) as received at the satellite. One frame of the burst signal input includes burst signals A to E as shown in Figure 2(a). The burst signals A to E are respectively distributed to slave stations (terrestrial stations from the satellite) on a time division basis. Various forms of burst signal are possible but each basically has a structure as shown in Figure 2(b). That is, a burst signal has·a non-modulated portion CR, for triggering a reference carrier recovery circuit, a clock recovery portion BTR consisting of "1", "0" patterns for clock recovery, a preamble word PW containing a variety of control information etc, and a data portion DATA.

Assuming that a burst signal as explained above is received, the operations of the circuit shown in Figure 1 will be explained.

The PSK modulated wave signal received at the input terminal 1 is sent to the mixing means 2 and is mixed with an output of the voltage controlled oscillator 5. This provides frequency conversion and a converted signal, of a different frequency from the PSK signal, is extracted from the mixing means 2. The converted signal, after frequency conversion, is input to the frequency discriminating means 3 which provides a DC voltage level representing the difference between the frequency of the converted signal and a specified or nominal frequency.

A PSK modulated wave signal modulated by a random signal generally does not include a carrier component (non-modulated portion) and in such a case frequency error information (frequency difference level) cannot be obtained from an output of the frequency discriminating means 3. However, only a non-modulated carrier is transmitted in the abovementioned non-modulated portion CR of a burst signal as described above. Accordingly, in respect of CR, desired frequency error information can be obtained from an output of the frequency discriminator 3.

In the means 6 for detecting a non-modulated signal portion, a non-modulated portion CR in a burst signal is detected by the band-pass-filter 601, which allows such a non-modulated portion CR to pass. Means 602 for detecting a signal envelope detect an output signal from the filter 601 and output a corresponding DC voltage.

The output of the means 602 for detecting a signal envelope is compared with a specified threshold voltage at the voltage comparator 7 and thereby a pulse signal having a time width corresponding to the non-modulated portion CR of a burst signal is provided. This pulse signal is shown in Figure 2(c) in correspondence to the burst signal of Figure 2(b).

As described above, since desired frequency error information can be obtained from the frequency discriminating means 3 in respect of a non-modulated portion CR of a burst signal, a DC voltage proportional to frequency error can be obtained by sample-holding an output of the frequency discriminating means 3 using the pulse signal obtained from the voltage comparator 7 in correspondence to the non-modulated portion CR and by integrating the sampled and held values. The sample-holding and integrating processes are carried out in the sample-hold type integrating means 4, and an output of the sample-hold integrating means 4 is input to the voltage controlled oscillator 5 as an oscillation frequency control signal therefor.

The oscillation output of the voltage controlled oscillator 5 is frequency-controlled so that the output of the sample-hold integrating means 4 becomes 0. Thereby, the converted signal, obtained by frequency conversion from the mixing means 2, has a constant frequency. In other words, AFC is effected.

Below, respective components of the frequency converter embodying this invention as described with reference to Figure 1 will be explained.

As mixing means 2, voltage controlled oscillator 5 and voltage comparator 7, commercially available general-purpose components can be used and therefore detailed explanation of them will be omitted.

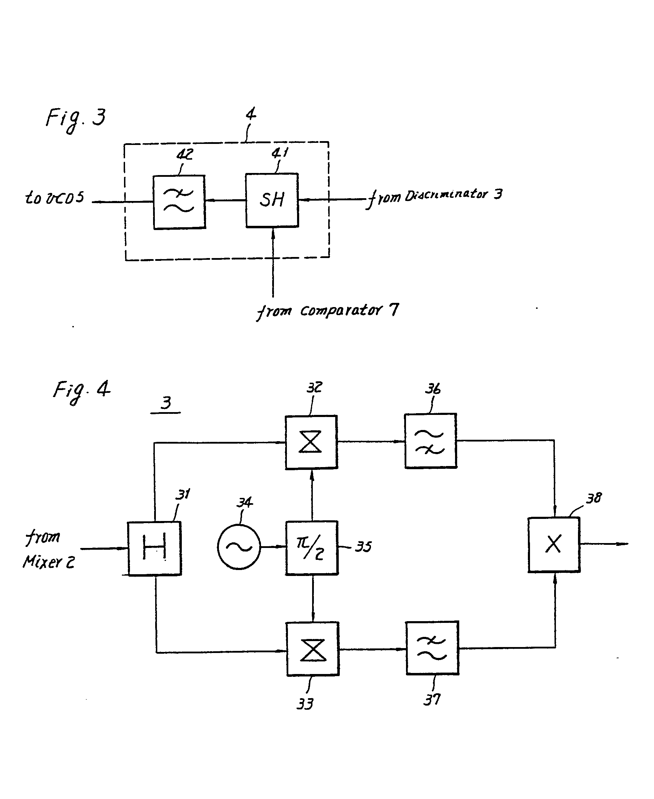

Figure 3 is a schematic block diagram indicating the structure of sample-hold type integrating means 4. In Figure 4, 41 is a sample-hold circuit and 42 is a lowpass filter. Generally, such sample-hold type integrating means can be formed and operated as a single circuit unit but the functions of those means can be indicated by the block structure of Figure 3.

The sample-hold circuit 41 samples an output signal from the frequency discriminating means 3 in reponse to a pulse signal obtained from the voltage comparator 7, then holds sampled values and provides an output based on the sampled values during the period in which the pulse signal from voltage comparator 7 is absent, i.e. until the pulse signal is input again. Low-pass-filter 42 extracts a DC component of an output of this sample-hold circuit 41 and outputs it as a control signal of the voltage controlled oscillator 5.

Figure 4 shows an example of structure of the frequency discriminating means 3. The circuit structure of Figure 4 is particularly constructed so as to satisfy the following requirements:—

(1) frequency discriminating sensitivity is changeable; and

(2) frequency discriminating sensitivity does not become zero even when input signal frequency goes beyond the cut-off frequency and therefore a cut-off frequency is lowered than the pull-in frequency range of AFC.

The frequency discriminating means 3 described here satisfy requirements (1) and (2) and therefore if the data transmission rate changes and accordingly the pull-in frequency range of AFC must be changed, and when it is required to effect improvement with regard to the limit of S/N ratio within which AFC operation can be achieved, it can be effectively adopted. However, if there is no need for such requirements to be satisfied resonant type frequency discriminating means can of course be used.

In Figure 4, 31 is a hybrid circuit which divides the signal sent from the mixing means 2 so that it travels along two routes; 32 and 33 are mixing means; 34 is an oscillator; 35 is a 90° hybrid circuit providing signals having a phase differ-

ence of $\pi/2$ respectively on the basis of the output from the oscillator 34; 36 and 37 are high-pass and low-pass filters which have the same cut-off frequency and the same dimensional orders; and 38 is a multiplier acting as mixing means.

An output signal from the mixing means 2 is divided, so as to travel along two routes, by the hybrid circuit 31 and the divided signals are respectively mixed, in the mixing means 32 and 33, with local oscillation signals having a phase difference of 90° and provided by hybrid circuit 35. Accordingly, beat signals having a phase difference of 90° can be obtained from the mixing means 32 and 33.

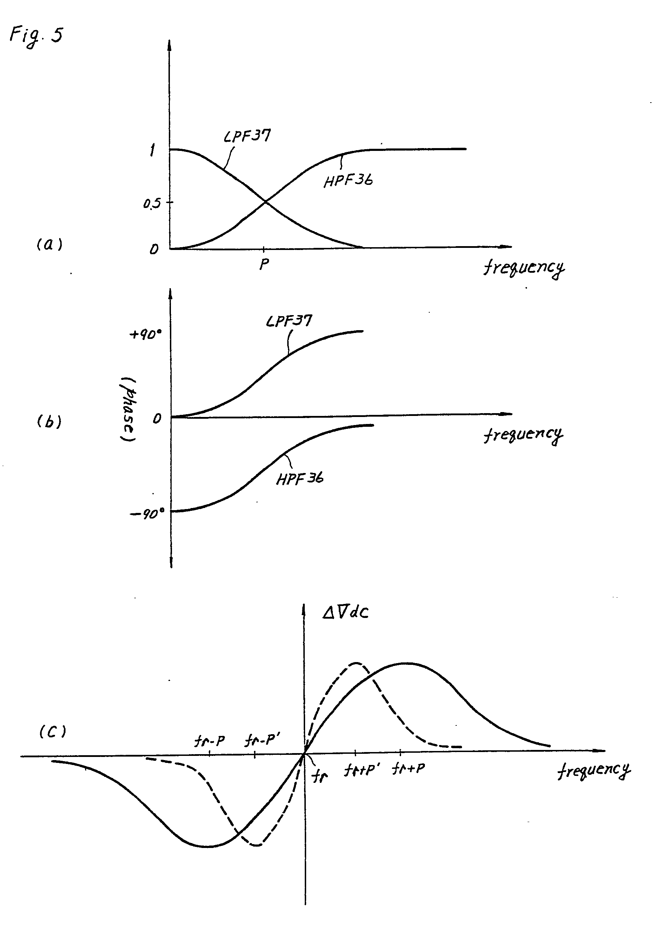

The graph of Figure 5(a) illustrates first characteristics of the high-pass-filter 36 and the low-pass filter 37 in Figure 4. Here the first characteristics are the amplitude-frequency characteristics of the filters. In this graph, LPF 37 and HPF 36 are respectively the first characteristic curves of the low-pass-filter and high-pass-filter.

In the graph of Figure 5(a), amplitudes are shown normalized, to give values such as 1, 0.5. When the frequency of a signal input thereto is 0, 37 gives an output of normalized amplitude 1, whilst 36 gives an output of normalized amplitude 0. When the frequency of a signal input thereto becomes high, the output amplitude of 37 converges to zero whilst that of 36 converges to 1. Here, it should be noted that both filters 37 and 36 have the same cut-off frequency P (amplitude 0.5). By giving filters 37 and 36 the same cut-off frequency as explained above, an almost cubic curve giving constant or stationary DC voltages $\Delta V_{dc}$ corresponding to the extreme values of $+0.25$ and $-0.25$ ($0.25=0.5\times0.5$) for the frequencies of $f_r+P$ and $f_r-P$ can be obtained in the discriminating characteristic shown in Figure 5(c) (see below).

The graph of Figure 5(b) illustrates second characteristics of the high-pass-filter 36 and low-pass-filter 37 in Figure 4. Here the second characteristics are the phase-frequency characteristics of the filters. In this graph, HPF 36 and LPF 37 are respectively second characteristic curves of the high-pass-filter and low-pass-filter 36 and 37.

Supplied with an input frequency of 0, HPF 36 provides a phase difference (between its input and its output) of $-90°$, and as input frequency increases, the phase difference converges to zero. On the other hand, LPF 37 provides a phase difference of 0 when its input frequency is 0 and when a frequency increases, the phase difference converges to $+90°$. From the characteristics of the graph of Figure 5(b), it will be seen that the input signals to 36 and 37 have, when output therefrom, suffered a relative phase shift (one with respect to the other) which is constant irrespective of input signal frequency. This corresponds to the shifting of the output phase of mixing means 32, by means of a differential circuit, to make that output phase the same as the output phase of mixing means 33.

Namely, if the output frequency of the oscillator 34 is taken to be $f_{r'}$, the input frequency from mixing means 2 is taken to be $f_{m'}$, and the frequency error information relating to $f_{r'}$ and $f_{m'}$ is

$$\Delta w(=f_r-f_m),$$

the output of mixing means 32 is proportional to sin $(\Delta wt)$, whilst an output of the mixing means 33 is proportional to cos $(\Delta wt)$, respectively. However, by the structure of Figure 4, the output of the mixing means 32 is equivalently differentiated (by 36 and 37) and an output proportional to $\Delta w \cdot \cos (\Delta w't)$ is obtained, whilst at the multiplier 38, an output proportional to

$$\Delta w \cdot \cos(\Delta w't) \times \cos(\Delta w't)= \Delta w\{1+\cos2(\Delta w't)\}$$

is obtained. Here, $\Delta w'$ indicates frequency error information when $\Delta w$ is shifted by high-pass-filter 36 and low-pass-filter 37. In addition, the outputs of the mixing means 32 and 33 are input to the filters 36 and 37 with a phase difference of 90°, but thereafter, as shown in Figure 5(b), the filters impose a relative phase shift of 90° so that the outputs from the filters, and hence the inputs to the multiplier 38 are signals of the same phase.

As a result, frequency error information $\Delta w$ can be detected as a DC voltage level $\Delta V_{dc}$ by extracting a DC component from an output of said multiplier 38,

$$\Delta w\{1+\cos2(\Delta w't)\}.$$

The graph of Figure 5(c) illustrates the output characteristic of the multiplier in Figure 4. In this graph, the horizontal axis indicates frequency (receiving frequency from mixing means 2 after frequency conversion), while the vertical axis indicates DC voltage $\Delta V_{dc}$. Here, the first notable characteristic is that even if frequency goes beyond limits $f_r+P$ (P is a filter cut-off frequency) or $f_r-P$, $\Delta V_{dc}$ does not immediately change to zero but gradually reaches zero over a constant band width. This means that discrimination sensitivity is not eliminated if the cut-off frequency P is set to a lower value, and therefore, the pull-in frequency range of AFC can be widened relatively. That is, the limit of S/N ratio within which AFC operation can be ensured can be improved. The second notable characteristic is that when the cut-off frequency P is shifted to P', an almost cubic curve is maintained while the maximum and minimum levels of $\Delta V_{dc}$ remain constant. As explained, with reference to Figure 5(a), this is so because the cut-off frequencies P of the high-pass-filter and low-pass-filter 36, 37 are set to be equal (amplitude is 0.5, normalized value). Namely, $\Delta V_{dc}$ kept constant corresponds to a constant value of 0.25 (0.5×0.5). As a result, gradient of the almost linear part of the dotted line curve (cut-off frequency of P') becomes sharp (discrimination sensitivity becomes high) as compared with the gradient of the linear part of the solid line curve (cut-off frequency of P) shown in Figure 5(c). When a discrimination sensitivity can be adjusted, data transmission can efficiently follow a change of transmission rate.

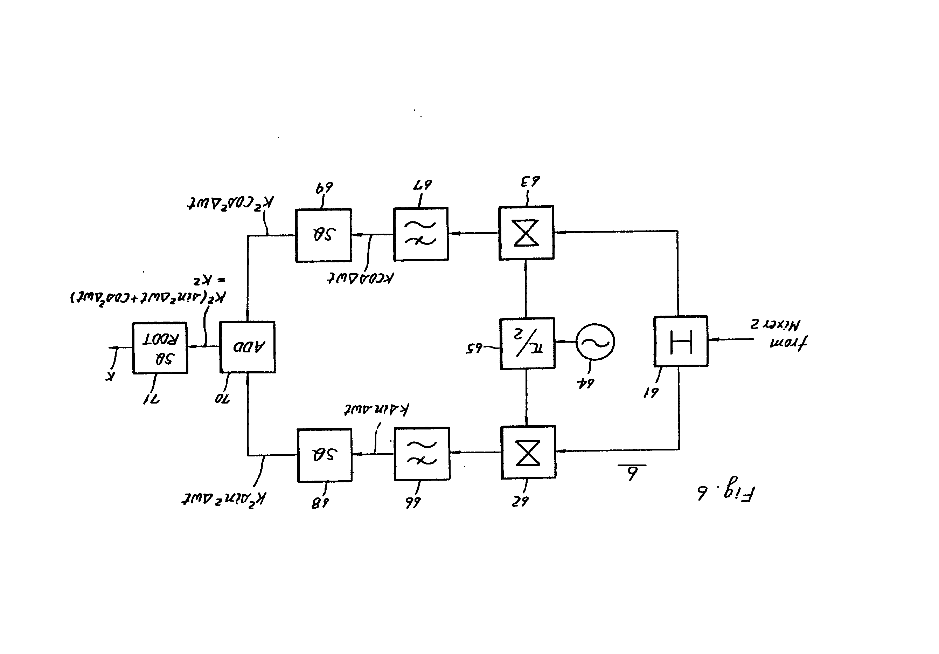

Figure 6 is an example of the structure of the means for detecting a non-modulated signal portion. The means 6 for detecting a non-modulated signal portion has functions corresponding to those of a circuit in which a band pass filter (601) (BPF 601), which allows only a specified frequency signal to pass, and means 602 for extracting a signal envelope, are connected in series. In addition, the circuit structure of Figure 6 provides that the center frequency of the band pass filtering characteristic can be easily matched to a specified non-modulated received signal portion and the pass-band width can also be changed easily. In a structure in which a band-pass-filter and a detector were connected in series, the center frequency and band width could be changed only by changing a band-pass-filtering characteristic of a band-pass filter, and this is very difficult.

Operations of the means 6 for extracting the non-modulated portion as shown in Figure 6 will now be described.

In Figure 6, 61 is a hybrid circuit; 64 is a local oscillator; 65 is a 90° hybrid circuit; 62 and 63 are mixing means; 66 and 67 are low-pass-filters; 68 and 69 are square circuits; 70 is an adder; and 71 is a square root circuit.

An output signal from the mixing means 2 (Figure 1) is branched along two routes by the hybrid circuit 61, and signals along these routes are respectively applied to first input terminals of the mixing means 62 and 63. Second input terminals of the mixing means 62 and 63 are supplied with output signals derived from local oscillating means 64 which are in phase quadrature. Therefore, the outputs of the mixing means 62 and 63, from which harmonics are removed by the low-pass-filters 66 and 67 respectively, correspond to $K\sin\Delta wt$, $K\cos\Delta wt$. Here, K is a constant proportional to input signal amplitude, and $\Delta w$ corresponds to frequency error information giving the frequency error between the output frequency $f_r$ of the oscillating means 64 and the input frequency $f_m$ from mixing means 2 as in the case of Fig. 4. The outputs of the low-pass-filters 66 and 67 are squared by the circuits 68 and 69 and thereby signals corresponding to $K^2\sin^2\Delta wt$ and $K^2\cos^2\Delta wt$ are obtained. The signals obtained from the square circuits 68, 69 are added in the adder 70 and thereby an output proportional to

$$K^2(\sin^2\Delta wt+\cos^2\Delta wt)$$

is obtained. Here, since

$$(\sin^2\Delta wt+\cos^2\Delta wt)=1,$$

a signal corresponding to the square value of input signal amplitude $K^2$ is obtained from the adder 70. Thereafter, the square root circuit 71 executes the operation $\sqrt{K^2}=K$ and thereby an output corresponding to input signal amplitude is obtained.

The oscillation frequency of oscillator 64 sets the center frequency of the band-pass characteristic and the band-pass bandwidth is determined by the filtering characteristics of the low-pass-filters 66 and 67. Accordingly, characteristics can be adjusted easily.

In the circuit structure shown in Figure 6, square circuits 68, 69 are used but these can be replaced with absoluting circuits. In such a case, the absolute values of $K\sin\Delta wt$, $K\cos\Delta wt$, which are outputs of the low-pass-filters 66 and 67, are obtained, doubles (square) components of each signal are extracted therefrom, and a sum of these values is obtained. As a result, a DC component $K'$ corresponding to the amplitude of input signal can be obtained. An output of the adder circuit 70 contains above DC component $K'$ and simultaneously a quadruple component of $\sin\Delta wt$. Therefore, it is desirable to provide in following circuit stages adequate means for waveform shaping and level shifting, in place of the square root circuit 71.

As is obvious from comparison between the means 6 shown in Figure 6 and the frequency discriminating means 3 shown in Figure 4, the circuit structures of these means, up to the mixing means (62, 63 (32, 33) for quadrative detection are the same. Thus, one circuit structure can be used in common and thereby the cost of a frequency converter as a whole can be reduced.

As described above, according to an embodiment of this invention, an oscillation frequency of a voltage controlled oscillator can be changed easily in accordance with fluctuation of input signal frequency without using a pilot signal. Thereby, a communication frequency band can be used effectively and high system reliability can be obtained through prevention of system failures due to abnormalities at a station from which the pilot signal is transmitted.

This invention is concerned with automatic frequency control in relation to a frequency converter for example in a time division communication system, where a non-modulated signal portion, contained in the burst signal for example, is selectively frequency discriminated, and a frequency discrimination output derived from the non-modulated signal portion is held for a certain period of time and that output is then used as an oscillation frequency control signal for local oscillating means employed for demodulation.

**Claims**

1. A frequency converter, comprising:—
a voltage controlled oscillator (5) for generating a local signal;
mixing means (2), connected to receive the local signal and arranged to receive an input signal to be frequency converted, operable to mix the local signal and the input signal to provide a frequency converted output signal; and
discriminating means (3) connected to receive the frequency converted output signal, operable to detect error in the frequency of that signal and to provide an error signal indicative of such error, the voltage controlled oscillator (5) being controlled to alter the frequency of the local signal, to reduce such error, in dependence upon the error signal;
characterised in that the frequency converter further comprises:—
means (6) for detecting a non-modulated portion (CR) of the input signal, on the basis of the frequency converted output signal, and to provide a control signal in correspondence to the detection of such a non-modulated portion (CR),; and
means (4) operable under control of the said control signal to provide an error value based on the error signal output of the discriminating means (3) when the non-modulated portion (CR) of the input signal is detected;
the voltage controlled oscillator (5) being controlled on the basis of said error value when providing the local signal for frequency conversion of a modulated portion (for example, BTR, PW, DATA) of the input signal received after the said non-modulated portion (CR).

2. A frequency converter as claimed in claim 1, wherein the means (4) operable to provide said error value are constituted by integrating means (41, 42) of the sample-hold type, operable to integrate the error signal and hold a resultant error value under control of the said control signal.

3. A frequency converter as claimed in claim 1 or 2, wherein the means (6) for detecting the non-modulated portion (CR) of the input signal are operable to detect the envelope of the non-modulated portion (CR).

4. A frequency converter as claimed in claim 1, 2 or 3, wherein the means (4) operable to provide said error value comprise:—
sample-hold means (41), for sampling and holding the error signal output of the discriminating means (3) under control of the said control signal; and
a low-pass filter (42), connected to the sample-hold means (41), for filtering the output of the sample-hold means (41) to provide a DC signal as the said error value.

5. A frequency converter as claimed in claim 1, 2, 3 or 4, wherein the discriminating means comprise:
a hybrid circuit (31), connected to receive the said frequency converted output signal from the mixing means (2), for dividing that signal to provide first and second output signals;
further mixing means (32, 33), operatively connected to the hybrid circuit (31), for mixing the first and second output signals with respective locally generated signals that are in phase quadrature with one another to provide third and fourth output signals;

a high-pass filter (36), connected to the further mixing means, for receiving and filtering the third output signal;

a low-pass filter (37), connected to the further mixing means, having a cut-off frequency and dimensional orders the same as those of the high-pass filter, for receiving and filtering the fourth output signal; and

additional mixing means (38) connected for receiving the filtered signals from the high-pass filter and the low-pass filter, for mixing the filtered signals to provide the error signal.

6. A frequency converter as claimed in any preceding claim, wherein the means (6) for detecting a non-modulated portion (CR) of the input signal comprise:—

a hybrid circuit (61) connected to receive the said frequency converted output signal, for dividing that signal to provide first and second divided signals;

further mixing means (62, 63) operatively connected to the hybrid circuit (61), for mixing the first and second divided signals with respective locally generated signals in phase quadrature with one another to provide third and fourth divided signals;

first and second squaring means (68, 69) operatively connected to said further mixing means (62, 63) to receive the third and fourth divided signals via respective low-pass-filters (66, 67) to provide first and second squared signals respectively; and

adder means (70) operatively connected to the first and second squaring means to provide a sum signal from the first and second squared signals.

7. A frequency converter as claimed in claim 6, wherein the means (6) for detecting a non-modulated portion (CR) of the input signal further comprise square root means (71) operatively connected to the adder means (70) to receive the sum signal from the adder means, to provide a signal in proportion to the envelope of the amplitude of the non-modulated portion (CR) of the input signal.

8. A frequency converter as claimed in claim 1, 2, 3 or 4, wherein the means (6) for detecting a non-modulated portion (CR) of the input signal comprise:—

a hybrid circuit (61) connected to receive the said frequency converted output signal, for dividing that signal to provide first and second divided signals;

further mixing means (62, 63) operatively connected to the hybrid circuit, for mixing the first and second divided signals with respective locally generated signals in phase quadrature with one another to provide third and fourth divided signals;

first and second absoluting means operatively connected to said further mixing means to receive the third and fourth divided signals via respective low-pass filters (66, 67), to provide first and second absolute value signals respectively; and

an adder circuit operatively connected to the first and second absoluting means to provide the sum signal of the first and second absolute value signals.

9. A frequency converter as claimed in any one of claims 6, 7 or 8, wherein the hybrid circuit (31) of the discriminating means and the hybrid circuit (61) of the means (6) for detecting a non-modulated portion (CR) of the input signal are one and the same, and wherein the further mixing means (32, 33) of the discriminating means and the further mixing means (62, 63) of the means (6) for detecting a non-modulated portion (CR) of the input signal are one and the same.

10. A frequency converter as claimed in any preceding claim, adapted for use in a case in which the input signal is a PSK burst signal of a time division multiple access communication system.

**Patentansprüche**

1. Frequenzumsetzer, miteinem spannungsgesteuerten Oszillator (5) Erzeugen eines lokalen Signals;

einer Mischeinrichtung (2), die angeschlossen ist, um das lokale Signal zu empfangen, und angeordnet ist, um ein Eingangssignal zu empfangen, dessen Frequenz umgesetzt werden soll, und betreibbar ist, um das lokale Signal und das Eingangssignal zu mischen, um ein Ausgangssignal mit umgesetzter Frequenz zu liefern; und

einer Diskriminatoreinrichtung (3), die angeschlossen ist, um das Ausgangssignal mit umgesetzter Frequenz zu empfangen, und betreibbar ist, um einen Fehler in der Frequenz von jenem Signal zu detektieren und um ein Fehlersignal zu liefern, das einen solchen Fehler anzeigt, wobei der spannungsgesteuerte Oszillator (5) gesteuert wird, um die Frequenz des lokalen Signals zu ändern, um solch einen Fehler, in Abhängigkeit von dem Fehlersignal, zu reduzieren;

dadurch gekennzeichnet, daß der Frequenzumsetzer ferner umfaßt:—

Einrichtungen (6) zum Detektieren eines nicht-modulierten Abschnitts (CR) des Eingangssignals, auf der Basis des Ausgangssignals mit umgesetzter Frequenz, und um ein Steuersignal in Entsprechung mit der Detektion von solch einem nicht-modulierten Abschnitt (CR) zu liefern; und

eine Einrichtung (4), die unter der Steuerung des genannten Steuersignals betreibbar ist, um einen Fehlerwert basierend auf dem Fehlersignalausgang der Diskriminatoreinrichtung (3) zu liefern, wenn der nicht-modulierte Abschnitt (CR) des Eingangssignals detektiert wird;

und der spannungsgesteuerte Oszillator (5) auf der Basis des genannten Fehlerwertes gesteuert wird, wenn das lokale Signal zur Frequenzumsetzung eines modulierten Abschnitts (zum Beispiel BTR, PW, DATA) des Eingangssignals geliefert wird, das nach dem genannten nicht-modulierten Abschnitt (CR) empfangen wird.

2. Frequenzumsetzer nach Anspruch 1, bei dem die Einrichtung (4) die betreibbar ist, um den genannten Fehlerwert zu liefern, aus integrierenden Einrichtungen (41, 42) vom Abtastwert-Haltetyp aufgebaut ist, die betreibbar ist, um das Fehlersignal zu integrieren und einen resultierenden Fehlerwert unter der Steuerung des genannten Steuersignals zu halten.

3. Frequenzumsetzer nach Anspruch 1 oder 2, bei dem die Einrichtungen (6) zum Detektieren des nicht-modulierten Abschnitts (CR) des Eingangssignals betreibbar sind, um die Umhüllende des nicht-modulierten Abschnitts (CR) zu detektieren.

4. Frequenzumsetzer nach Anspruch 1, 2 oder 3, bei dem die Einrichtung 4, die betreibbar ist, um den genannten Fehlerwert zu liefern, umfaßt:—

eine Abtastwert-Halteeinrichtung (41), um den Fehlersignalausgang von der diskriminierenden Einrichtung (3) unter Steuerung des genannten Steuersignals abzutasten und zu halten; und

einen Tiefpaßfilter (42), der mit der Abtastwert-Halteeinrichtung (41) verbunden ist, um den Ausgang der Abtastwert-Halteeinrichtung (41) zu filtern, um ein Gleichstromsignal als den genannten Fehlerwert zu liefern.

5. Frequenzumsetzer nach Anspruch 1, 2, 3 oder 4, bei dem die diskriminierende Einrichtung umfaßt:

eine Hybridschaltung (31), die angeschlossen ist, um das genannte Ausgangssignal mit umgesetzter Frequenz von der Mischeinrichtung (2) zu empfangen, um jenes Signal zu teilen, um erste und zweite Ausgangssignale zu liefern;

ferner Mischeinrichtungen (32, 33), die wirkungsmäßig mit der Hybridschaltung (31) verbunden sind, um die ersten und zweiten Ausgangssignale mit entsprechenden lokal generierten Signalen zu mischen, welche in Phasenquadratur miteinander stehen, um dritte und vierte Ausgangssignale zu liefern;

einen Hochpaßfilter (36), der mit der weiteren Mischeinrichtung verbunden ist, um das dritte Ausgangssignal zu empfangen und zu filtern;

einen Tiefpaßfilter (37), der mit der weiteren Mischeinrichtung verbunden ist, und eine Grenzfrequenz und dimensionale Ordnungen gleich jenen des Hochpaßfilters hat, um das vierte Ausgangssignal zu empfangen und zu filtern; und

zusätzliche Mischeinrichtungen (38), die verbunden sind, um die gefilterten Signale von dem Hochpaßfilter und dem Tiefpaßfilter zu empfangen, um die gefilterten Signale zu mischen, um das Fehlersignal zu liefern.

6. Frequenzumsetzer nach einem der vorhergehenden Ansprüche, bei dem die Einrichtungen (6) zum Detektieren eines nicht-modulierten Abschnitts (CR) des Ausgangssignals umfassen:—

eine Hybridschaltung (61), die angeschlossen ist, um das genannte Ausgangssignal mit umgesetzter Frequenz zu empfangen, um jenes Signal zu teilen, um erste und zweite geteilte Signale zu liefern;

ferner Mischeinrichtung (62, 63), die wirkungsmäßig mit der Hybridschaltung (61) verbunden sind, um die ersten und zweiten geteilten Signale mit entsprechenden lokal generierten Signalen in Phasequadratur miteinander zu mischen, um dritte und vierte geteilte Signale zu liefern;

erste und zweite Quadriereinrichtungen (68, 69) die wirkungsmäßig mit der genannten weiteren Mischeinrichtung (62, 63) verbunden sind, um die dritten und vierten geteilten Signale über jeweilige Tiefpaßfilter (66, 67) zu empfangen, um erste bzw. zweite quadrierte Signale zu liefern; und

Addiereinrichtungen (70), die wirkungsmäßig mit der ersten und zweiten Quadriereinrichtung verbunden sind, um ein Summensignal von den ersten und zweiten quadrierten Signalen zu liefern.

7. Frequenzumsetzer nach Anspruch 6, bei dem die Einrichtung (6) zum Detektieren eines nicht-modulierten Abschnitts (CR) des Eingangssignals ferner Quadratwurzeleinrichtungen (71) umfaßt, die wirkungsmäßig mit der Addiereinrichtung (70) verbunden sind, um das Summensignal von der Addiereinrichtung zu empfangen, und um ein Signal in Proportion mit der Umhüllenden der Amplitude des nicht-modulierten Abschnitts (CR) des Eingangssignals zu liefern.

8. Frequenzumsetzer nach Anspruch 1, 2, 3 oder 4, bei dem die Einrichtung (6) zum Detektieren eines nichtmodulierten Abschnitts (CR) des Eingangssignals umfaßt:—

eine Hybridschaltung (61), die angeschlossen ist, um das genannte Ausgangssignal mit umgesetzter Frequenz zu empfangen, um jenes Signal zu teilen, um erste und zweite geteilte Signale zu liefern;

ferner Mischeinrichtung (62, 63), die wirkungsmäßig mit der Hybridschaltung verbunden sind, um die ersten und zweiten geteilten Signale mit entsprechenden lokal generierten Signalen in Phasenquadratur miteinander zu mischen, um dritte und vierte geteilte Signale zu liefern;

erste und zweite den Absolutwert bildende Einrichtungen wirkungsmäßig mit der genannten weiteren Mischeinrichtung verbunden sind, um die dritten und vierten geteilten Signale über jeweilige Tiefpaßfilter (66, 67) zu empfangen, um erste bzw. Absolutwert-Signale zu liefern; und

eine Addierschaltung, die wirkungsmäßig mit der ersten und zweiten den Absolutwert bildenden Einrichtung verbunden sind, um das Summensignal von den ersten und zweiten Absolutwertsignalen zu liefern.

9. Frequenzumsetzer nach einem der Ansprüche 6, 7 oder 8, bei dem die Hybridschaltung (31) der diskriminierenden Einrichtung und die Hybridschaltung (61) der Einrichtung (6) zum Detektieren eines nicht-modulierten Abschnitts (CR) des Eingangssignals ein und dieselbe sind, und bei der die weiteren Mischeinrichtungen (32, 33) der diskriminierenden Einrichtungen und die weiteren Mischeinrichtungen (62, 63) der Einrichtungen (6) zum Detektieren eines nicht-modulierten Abschnitts (CR) des Eingangssignals ein und dieselbe sind.

10. Frequenzumsetzer nach einem der vorhergehenden Ansprüche, angepaßt zur Verwendung in einem Gehäuse, in dem das Eingangssignal ein PSK-Burst-Signal eines Vermittlungssystems mit Zeitteilung und Vielfachzugriff ist.

**Revendications**

1. Convertisseur de fréquence comportant:

un oscillateur commandé par tension (5) destiné à produire un signal local,

un dispositif mélangeur (2) connecté pour recevoir le signal local et agencé pour recevoir un signal d'entrée à convertir en fréquence, ayant pour fonction de mélanger le signal local et le signal d'entrée afin de produire un signal de sortie converti en fréquence, et

un dispositif discriminateur (3) connecté pour recevoir le signal de sortie converti en fréquence, ayant pour fonction de détecter une erreur dans la fréquence de ce signal et de produire un signal d'erreur indiquant cette erreur, l'oscillateur commandé par tension (5) étant commandé pour modifier la fréquence du signal local afin de réduire cette erreur en fonction du signal d'erreur, caractérisé en ce que le convertisseur de fréquence comporte en outre:

un dispositif (6) destiné à détecteur une partie non modulée (CR) dans le signal d'entrée, sur la base du signal de sortie converti en fréquence et de produire un signal de commande en correspondance avec la détection de cette partie non modulée (CR), et

un dispositif (4) ayant pour fonction, à la commande dudit signal de commande, de produire une valeur d'erreur basée sur le signal d'erreur émis par le dispositif de discrimination (3) quand la partie non modulée (CR) du signal d'entrée est détectée,

l'oscillateur commandé par tension (5) étant commandé sur la base de ladite valeur d'erreur en produisant le signal local pour la conversion de fréquence d'une partie modulée (par exemple BTR, PW, DATA) du signal d'entrée reçu après ladite partie non modulée (CR).

2. Convertisseur de fréquence selon la revendication 1, dans lequel le dispositif (4) ayant pour fonction de produire ladite valeur d'erreur est constitué par un dispositif intégrateur (41, 42) du type à échantillonnage et maintien ayant pour fonction d'intégrer le signal d'erreur et de maintenir une valeur d'erreur résultante à la commande dudit signal de commande.

3. Convertisseur de fréquence selon la revendication 1 ou 2, dans lequel le dispositif (6) de détection de la partie non modulée (CR) du signal d'entrée a pour fonction de détecter l'enveloppe de la partie non modulée (CR).

4. Convertisseur de fréquence selon la revendication 1, 2 ou 3, dans lequel le dispositif (4) ayant pour fonction de produire ladite valeur d'erreur comporte:

un dispositif d'échantillonnage et maintien (41) destiné à échantillonner et à maintenir la sortie du signal d'erreur du dispositif de discrimination (3) à la commande dudit signal de commande, et un filtre passe-bas (42) connecté au dispositif d'échantillonnage et maintien (41) pour filtrer la sortie du dispositif d'échantillonnage et maintien (41) et pour produire un signal continu comme ladite valeur d'erreur.

5. Convertisseur de fréquence selon la revendication 1, 2, 3 ou 4, dans lequel le dispositif discriminateur comporte:

un circuit hybride (31) connecté pour recevoir ledit signal de sortie converti en fréquence provenant du dispositif mélangeur (2) pour diviser ce signal et produire un premier et un second signaux de sortie,

un autre dispositif mélangeur (32, 33) connecté en fonctionnement au circuit hybride (31) pour mélanger le premier et le seconde signaux de sortie avec des signaux produits localement qui sont en quadrature de phase entre eux afin de produire un troisième et un quatrième signaux de sortie,

un filtre passe-haut (36) connecté à l'autre dispositif mélangeur pour recevoir et filtrer le troisième signal de sortie,

un filtre passe-bas (37) connecté à l'autre dispositif mélangeur, ayant une fréquence de coupure et des ordres de dimensions qui sont les mêmes que ceux du filtre passe-haut pour recevoir et filtrer le quatrième signal de sortie, et

un dispositif mélangeur supplémentaire (38) connecté pour recevoir les signaux filtrés provenant du filtre passe-haut et du filtre passe-bas, pour mélanger les signaux filtrés et produire le signal d'erreur.

6. Convertisseur de fréquence selon l'une quelconque des revendications précédentes, dans lequel le dispositif (6) de détection d'une partie non modulée (CR) du signal d'entrée comporte:

un circuit hybride (61) connecté de manière à recevoir ledit signal de sortie converti en fréquence, pour diviser ce signal et produire ainsi un premier et un second signaux divisés,

un autre dispositif mélangeur (62, 63) connecté en fonctionnement avec le circuit hybride (61) afin de mélanger le premier et le second signaux divisés avec des signaux respectifs produits localement en quadrature de phase entre eux et pour produire un trosième et un quatrième signaux divisés,

un premier et un second dispositifs d'élévation au carré (68, 69) connectés en fonctionnement audit autre dispositif mélangeur (62, 63) pour recevoir le troisième et le quatrième signaux divisés par des filtres passe-pas respectifs (66, 67) afin de produire respectivement un premier et un second signaux élevés au carré, et

un dispositif additionneur (70) connecté en fonctionnement avec le premier et le second dispositifs d'élévation au carré afin de produire un signal de somme du premier et du second signaux élevés au carré.

7. Convertisseur de fréquence selon la revendication 6, dans lequel le dispositif (6) de détection d'une partie non modulée (CR) du signal d'entrée comporte en outre un dispositif d'extraction de racine carrée (71) connecté en fonctionnement avec le dispositif additionneur (70) pour recevoir le signal de somme provenant du dispositif additionneur, pour produire un signal en proportion avec l'enveloppe de l'amplitude de la partie non modulée (CR) du signal d'entrée.

8. Convertisseur de fréquence selon la revendication 1, 2, 3 ou 4, dans lequel le dispositif (6) de détection d'une partie non modulée (CR) du signal d'entrée comporte:

un circuit hybride (61) connecté pour recevoir ledit signal de sortie converti en fréquence, pour diviser ce signal et produire un premier et un second signaux divisés,

un autre dispositif mélangeur (62, 63) connecté en fonctionnement au circuit hybride pour mélanger le premier et le second signaux divisés avec des signaux respectifs produits localement, en quadrature de phase entre eux afin de produire un troisième et un quatrième signaux divisés,

un premier et un second dispositifs d'établissement de valeur absolue connectés en fonctionnement audit autre dispositif mélangeur pour recevoir le troisième et le quatrième signaux divisés par des filtres passe-bas respectifs (66, 67) afin de produire respectivement un premier et un second signaux de valeurs absolues, et

un circuit additionneur connecté en fonctionnement au premier et au second dispositifs de détermination de valeur absolue pour produire le signal de somme du premier et du second signaux de valeur absolue.

9. Convertisseur de fréquence selon l'une quelconque des revendications 6, 7 ou 8, dans lequel le circuit hybride (31) du dispositif discriminateur et le circuit hybride (61) du dispositif (6) de détection d'une partie non modulée (CR) du signal d'entrée sont un seul et même et dans lequel l'autre dispositif mélangeur (32, 33) du dispositif discriminateur et l'autre dispositif mélangeur (62, 63) du dispositif (6) de détection d'une partie non modulée (CR) du signal d'entrée sont un seul et le même.

10. Convertisseur de fréquence selon l'une quelconque des revendications précédentes, agencé pour être utilisé dans un cas dans lequel le signal d'entrée est un signal de train PSK d'un système de télécommunications à accès multiple en division temporelle.

Fig. 1

PSK
signal

DISC — 3

SHI

COMP

DET

Fig. 2

1 frame

(a)

| A | B | C | D | E |

t

(b)

CR    BTR    PW    DATA

(C)

Fig. 3

to VCO 5 ← 42 (≈) ← 41 (SH) ← from Discriminator 3
4

from Comparator 7

Fig. 4

3

from Mixer 2 → 31 (H) → 34 (~) → 35 (π/2) → 32 (⊠) → 36 (≈) → 38 (X) →

33 (⊠) → 37 (≈)

2

Fig. 5

(a)

LPF37

HPF36

1

0.5

0

P

frequency

(b)

(phase)

+90°

0

−90°

LPF37

HPF36

frequency

(C)

ΔVdc

fr−P   fr−P'

fr   fr+P'   fr+P

frequency

3

Fig. 6

$6$

from Mixer 2

$61$ — H

$64$ — (~)

$65$ — $\pi/2$

$62$ — ⊠

$66$ — $\approx$    $k \sin \Delta wt$

$68$ — SQ    $K^2 \sin^2 \Delta wt$

$63$ — ⊠

$67$ — $\approx$    $K \cos \Delta wt$

$69$ — SQ    $K^2 \cos^2 \Delta wt$

$70$ — ADD

$71$ — SQ ROOT    $K$

$K^2(\sin^2 \Delta wt + \cos^2 \Delta wt) = K^2$